# EUROPEAN PATENT SPECIFICATION

(11) **EP 1 555 784 B1**
(45) Date of publication and mention of the grant of the patent: **22.03.2017**
(21) Application number: 04075124.0
(22) Date of filing: 19.01.2004
(51) Int. Cl.: H04L 25/03, H04L 25/08

(54) **Method and apparatus for optimizing tree pruning in a multiuser detector**
Verfahren und Vorrichtung für die Optimierung der Baumbeschneidung in einem Mehrbenutzendetektor
Méthode et dispositif pour optimiser la taille de l'arbre dans un détecteur multi-utilisateurs

(43) Date of publication of application: 20.07.2005
(73) Proprietor: Collision Communications, Inc., Peterborough NH 03458 (US)
(72) Inventor: Learned Rachel E., Bae Systems Info.&Elec.Sys.Int., Nashua, NH 03061-0868 (US)
(74) Representative: Brophy, David Timothy

(56) References cited:
- US-A1- 2003 138 065
- US-A1- 2003 138 065
- US-A1- 2003 193 966

## Description

### Related Application

This application is related to US Patent No. 6,947,505 (corresponding to US Patent Application Serial No. 09/943,770 filed August 31, 2001, entitled "System for Parametric Estimation and Tracking of Interfering Digitally Modulated Signals").

### Field of the Invention

This invention relates to the field of communications and more particularly to an improved method and apparatus in a receiver for multi-user detection utilizing tree pruning.

### Background of the Invention

The present invention belongs to the art of multiple access communications systems such as, but not limited to, wireless Local Area Networks (Wireless LANS), cellular land-mobile communications systems, mobile satellite communications systems, and memory storage and retrieval devices. Such systems are characterized by at least one fixed base or relay station attempting to maintain communications with a plurality of subscriber stations or terminals that are each assigned a different time slot (TDMA), a different frequency slot (FDMA), or different signature waveform (CDMA), to name a few examples.

In such systems, capacity to support a large number of subscribers is measured in units such as bits per second per Hertz per cell or other physical dimension such as a sector in a cellular system or square microns in a disk storage system. (e.g. the sum of the information data rates, Bits/sec, of all the users in the system). Of primary interest is the maximum number of users that can operate within the system without having to decrease the information rate that they are already accustomed to using or increase the total bandwidth occupied by the system. The capacity can be increased by using more MHz of bandwidth, by reducing the area covered by each base station so that there are more base stations per square kilometer, by decreasing the frequency spacing between channels, and by transmitting more than one signal in the same frequency channel or time slot. However, reducing cell size or reducing the number of signals received by the detector is not always possible or economically feasible. When such action is possible, it increases the infrastructure cost. In addition, some of the above listed solutions increase inter-symbol interference (ISI) and multi-user interference (MUI), also called co-channel interference. ISI is caused by a signal being received along with a delayed version thereof caused by a reflection of the signal from an object such as a large building. MUI discoursed by the receipt of another signal having the same frequency, often meant to be received at a different receiver. In addition, received signals are typically corrupted by additive Gaussian noise.

In order to be able to further accommodate increased traffic, and to make maximum utilization of a traffic channel, multiple interfering signals may be transmitted on the same communication channel and are purposely allowed to interfere with one another. The effects of the resulting multi-user interference are then removed at the receiver by a multi-user detector (MUD). Using a MUD does not require a change in the existing transmitted signaling method, making it an attractive option.

To separate multiple interfering signals transmitted on the same communication channel some unique apriori knowledge of each of the signals is required. For this purpose a parameter estimation unit is required, such as disclosed in US Patent No. 6,947,505. The parameter estimation required to attain this apriori knowledge may be done using "blind" parameter estimation, "non-blind" parameter estimation, or parameter estimation with the aid of training sequences. This last method is typically derived using a "training signal" or other knowledge of received signals in a manner well known in the art. The purpose of the parameter estimation unit is to identify and determine parameters associated with each signal that are required by the multi-user detector (MUD) to separate each signal from the other interfering signals, regardless of the fact that the signals exist in the same communications bandwidth and at the same instant in time. These parameters might include the received power, the phase of the oscillator which generated each received signal, the timing offset relative to the base station clock, carrier frequency, any frequency offset of the carrier, the assigned spreading code, and the structure of multi-path replicas.

To successfully demodulate simultaneously occurring interfering signals, signal processing of the received signal is accomplished utilizing multi-user detection (MUD) techniques. Early work in MUD, described in *Multi-user Detection* by S. Verdu, Cambridge University Press, 1998 proposed using computationally intense maximum likelihood (ML) exhaustive search techniques to separate the interfering signals. In certain applications, linear MUD detectors with lower computational demands may be used, and such MUD detectors are described by Verdu. However, the reduction in performance, particularly in high-interference situations, is so significant as to make those reduced complexity techniques not applicable. One method of implementing a ML is the well-known decoder known as the Viterbi decoder. A Viterbi decoder is based upon the Viterbi algorithm and performs a breadth first decoding search of all paths through an entire code tree (or trellis, which is a more compact representation of the code tree) by extending paths through the tree and the entire tree is searched. The complexity of the maximum likelihood (ML) Viterbi decoder in the context of many applications is prohibitively high.

The M-algorithm is a tree-pruning technique that approximates the operation of a ML Viterbi decoder at reduced complexity. The M-algorithm is a breadth first decoding algorithm, but with the M algorithm only the best M paths are retained at each level in the tree. This reduced tree search, referred to as "tree pruning", reduces the number of calculations that must be made and therefore speeds the overall tree processing.

Viterbi algorithm decoders and M algorithm decoders are also well known in the art as maximum likelihood decoders which can be used in systems that employ error correcting codes, such as convolutional codes, tree codes, and a variety of other codes, all of which can be generally characterized by a tree. The basic concept of these decoders can be described as correlating all possible transmitted sequences with the received sequence and then choosing as the "best" or "maximum likelihood" path the sequence whose correlation is a maximum.

A tree consists of a sequence of concatenations of a so-called tree diagram, or state transition diagram. The tree diagram defines, for each code state, which next state or states the encoder is allowed to transition to. The allowable transitions from one state to a next state are limited. Each possible transition from one state to a next state in a tree is called a branch. Each branch, therefore, corresponds to a subset. A sequence of signal points selected from a sequence of interconnected branches is called a path through the tree.

Transmitted signal points in signal space are displaced at the receiver due to noise and channel-induced distortion. In the case of a single transmitter and inter-symbol interference (ISI), or employment of a convolutional error correction code, a receiver may use a Viterbi algorithm decoder or an M algorithm decoder, operating on a received version of the stream of transmitted signal points, to perform the aforementioned maximum likelihood sequence detection or an approximation of ML sequence detection, respectively. Based on the received version of the transmitted signal points and the knowledge of the tree code used by the encoder and/or the ISI structure, the decoder determines the most likely sequence of signal points that was actually transmitted. The decoder performs this function by forming a decision as to what was the most likely transmitted signal point that would have caused the encoder to transition into a next state of the code. The technique works on concepts that can be modeled as a progression of states that branch out in a tree form. In the case of interfering signals, a tree can be formed that represents all possible choices of the transmitted values for all signals. That is, error correction coding is not necessarily assumed for tree decoding and doesn't necessarily dictate the formation of the tree. Rather, the tree is formed by the fact that different hypotheses for the received sequences are possible.

More particularly, a Viterbi algorithm decoder, an M algorithm decoder, or any other tree-search decoder forms paths through a tree by keeping track of so-called "metrics". A branch metric, a function of the received version of the signal point, is calculated for each current-to-next-state transition associated with each branch in the tree diagram. Every path through the tree which leads into a state has an associated path metric which is a function of the sum of the branch metrics for the branches that make up that particular path. Further, a path entering a current state may be extended through the tree and enter a next state by including a branch representing an allowed transition from the current state to the next state. The path metric for such an extended path is a function of the sum of (a) the path metric associated with the path as it entered the current state and (b) the branch metric associated with the included branch.

The Viterbi decoder compares the path metrics of the different paths entering a state and retains as one of the aforementioned surviving paths the path with the smallest path metric. All other paths entering that state are discarded. The surviving paths are used by the decoder to make a final decision as to the value of an earlier transmitted signal point.

To reduce the complexity of the tree search, thereby increasing the speed of testing multiple hypotheses, shortcuts may be deliberately taken in the processing with a tree decoder. For instance, the M-algorithm prunes the tree by retaining, at every stage in the tree, the best M paths through the tree. The computation complexity of a tree search is directly related to the number of hypotheses which must be tested, i.e. the number of paths through the tree which must be examined. For example, for an ML multi-user detector for which there are K interfering by binary phase shift keyed signals and which uses the Viterbi algorithm, the computational complexity is on the order of 2^{K} for each symbol interval. For the M-algorithm, the complexity is on the order of K^{1.2} for each symbol interval. The reduction in complexity by using the M-algorithm is considerable, but not for very large values of K or for high data rates the complexity reduction is not enough. In addition, tree pruning carries with it the risk that the correct path through the tree is eliminated from consideration, which causes a decoding error. Judicious pruning is required. For the M-algorithm, as M is decreased, the complexity is reduced by the probability of incorrect pruning increases. That is, the need for accuracy limits the reduction in complexity that is feasible. The M-algorithm is described in greater detail further in the Summary of the Invention. See also US Patent No. 6,151,370 issued November 21, 2000 which describes the M-algorithm. Tree pruning techniques also apply to maximum a posteriori (MAP) decoders.

To further improve the performance of a communication system, some coding schemes include interleavers at the transmitter, which mix up the order of the bits in each packet of bits during encoding. Thus, when interference destroys a few adjacent bits during transmission, the effect of the interference is spread out over the entire original packet and can more readily be overcome by the decoding process. Other improvements may include multiple-component codes which include coding the packet more than once in parallel or in series. However, as this invention is concerned with operation at the receiver, the interleavers included in the receiver are only the interleavers and de-interleavers that are necessary to reverse the operation of any interleaving done at the transmitter.

In short, despite all the decoding processing gains in the art there is still a need for an improved method and apparatus for signal processing simultaneously occurring, interfering signals to speed the decoding processing and allow for acceptable detection performance at real-time operational speeds.

Published US Patent Application No. 2003/0138065 discloses a real-time multi-user detection receiver that simultaneously processes a plurality of receiver signals from multiple users. The received signals are digitized prior to parameter estimation being performed to determine signal parameters for each individual user signal. Confidence ordering is used to generate a multiple surviving paths each one corresponding to a complete set of bit streams and the surviving paths are voted on prior to decoding to output data corresponding to a set of data bit streams.

### Summary of the Invention

In accordance with one aspect of the present invention, there is provided a method for decoding a plurality of received interfering user signals to obtain symbol estimates for each user signal, the received interfering user signals being received in blocks of data, the method comprising the steps of:-
a) defining a tree decoder having a number of node levels equal to the number of interfering user signals in the form of a tree having a root node, intermediate nodes an leaf nodes with branches connecting the root node and intermediate nodes to all nodes at the next higher node level;
b) uniquely defining each of the received interfering user signals in terms of a metric;
c) assigning the received interfering user signals to node levels within the tree based on the value of the defined metric at the beginning of a symbol interval where the first/highest order term of the metric to the first/root level of the tree decoder (13), assigning the second/next highest term of the metric to second level of the tree decoder (13), and so on; and
d) decoding the received interfering user signals to determine symbol estimates for each of the received interfering user signals and using the symbol estimates for each signal to determine a probability estimate for each of the symbols in each of the signals that is used in subsequent iterative decoding until a determination is made of the value of each symbol during a symbol interval.

During each iteration of decoding of a sequence of symbols, the most likely M channel symbol estimates at each level of the decoding tree are saved, and all the saved M channel symbol estimates are used to determine the best channel symbol estimate for each of the received interfering signals during each symbol interval.

It is preferred that the metric comprises the received signal strength of each of the user signals.

Preferably, step d) includes decoding the blocks of data to determine the symbol estimate for each of the interfering user signals therein.

The method further includes the step of repeating steps c) and d) for each symbol interval in each block of data. Step d) may include making a determination of the value of each symbol estimate after completion of the subsequent iterations of decoding during a symbol interval.

In accordance with another aspect of the present invention, there is provided apparatus for carrying out the method as described above, the apparatus comprising:- a multi-user tree decoder for decoding the received interfering user signals, the decoder having a number of node levels equal to the number of interfering user signals in the form of a tree having a root node, intermediate nodes an leaf nodes with branches connecting the root node and intermediate nodes to all nodes at the next higher node level from which symbols estimates are to be derived, the first/highest order term being assigned to the first/root node level of the tree, the second/next highest term being assigned to second node level of the tree, and so on; a parameter estimation unit for uniquely defining the interfering user signals in terms of a metric; an assembler for assigning interfering user signals to the node levels within the tree based on the value of the defined metric at the beginning of a symbol interval where the first/highest order term of the metric is assigned to the first/root level of the tree decoder, the second/next highest term of the metric to second level of the tree decoder, and so on; and a decoder bank for decoding the received interfering user signals to determine symbol estimates for each of the received interfering user signals and using the symbol estimates for each signal to determine a probability estimate for each of the symbols in each of the signals that is used in subsequent iterative decoding until a determination is made of the value of each symbol during a symbol interval.

In accordance with a further aspect of the present invention, there is provided a computer program for carrying out the method as described above.

In accordance with a still further aspect of the present invention, there is provided a computer readable medium containing the computer program as described above.

According to the present invention, a method for decoding a received signal to obtain symbol estimates for each user signal is provided. The received signal may comprise many interfering user signals and consist of multi-user interference. The method uses a multi-user decoder based on an algorithm defining a tree diagram, the tree diagram having a number of levels equal to the number of user signals. The first/highest order term of the metric is assigned to the first/root level of the tree, the second/next highest term of the metric is assigned to second level of the tree, and so on. The method comprises the steps of: (a) assigning the received, interfering signals being decoded to the levels of the decoder tree based on the power level of each received signal; and (b) decoding the signals to determine symbol estimates for each of the signals.

One of the received, interfering signals having the highest signal strength is assigned to the first/highest order term of the algorithm for decoding. The one of the signals having the second highest signal strength is assigned to the second/next highest order term of the algorithm for decoding, and so on.

According to the present invention, a method for decoding blocks of data from a single received signal comprised of many interfering user signals to obtain symbol estimates for each user's signal is provided. The method uses a multi-user decoder based on an algorithm defining a tree diagram having a number of node levels equal to the number of user signals known to comprise a received signal. The first/highest order term of the algorithm is assigned to the first/root node level of the tree, and the second/next highest term of the algorithm is assigned to second node level of the tree, and so on. The method for decoding the signals in each block of data comprises the steps of: (a) assigning the received, interfering user signals being decoded for a symbol interval being decoded to the node levels of the tree of the decoder based on the power level of each received signal; (b) decoding the block of data in the multi-user decoder to determine a symbol estimate for each of the user's signals therein; and (c) repeating steps (a) and (b) for each symbol interval to fully decode all symbols in each block of data making up the signals.

According to a further aspect apparatus for decoding received, interfering signals corrupted by multi-user interference to identify symbol estimates for each signal is provided. The apparatus uses a multi-user decoder based on an algorithm defining a tree diagram having a number of node levels equal to the number of signals from which the symbols estimates are derived. The first/highest order term of the algorithm is assigned to the first/root node level of the tree, and the second/next highest term of the algorithm is assigned to second node level of the tree, and so on. The apparatus comprises means for assigning users to the node levels of the tree based on the power level of each interfering user signal comprising the received signal; and means for decoding the signals in each block of data to determine symbol estimates for each of the signals.

According to yet a further aspect, a computer readable medium containing executable instructions for decoding received, interfering signals corrupted by multi-user interference to obtain symbol estimates for each transmitted signal is provided for carrying out the method described above.

According to another aspect of the invention, a method is provided for use in a decoder to decode a sequence of bits or symbols corresponding to a received signal that comprises a plurality of interfering signals from a plurality of interfering transmitters that is corrupted by inter-symbol interference and by other user interference in order to identify the value of bits or symbols for each of the received interfering signals. Decisions of the decoding process are carried out via a search using a tree decoder in which a tree diagram has a number of levels equal to the number of signals from which the corrupted received signal is comprised. The tree diagram has a plurality of nodes at each level corresponding to the possible values taken of a bit or symbol, and the tree comprises a root node, intermediate nodes and leaf nodes, and branches connect the root node and intermediate nodes to all nodes at the next higher level, and wherein a parameter estimator provides information about each of the interfering signals. The method comprises the steps of: (a) determining the received signal strength of each user or transmitter at the beginning of each symbol interval using information from the parameter estimator; (b) assigning the user or transmitter corresponding to the received signal determined to have the highest signal strength at the beginning of a symbol interval to the first level of the tree decoder diagram adjacent the tree root node for an iteration of decoding; (c) decoding the received signals in a multi-user detector to determine estimates for each symbol of the received interfering signal; (d) repeating step (c) for subsequent iterations of decoding during a symbol interval, with the symbol estimates determined in step (c) being used for a subsequent iteration of decoding; and (e) making a determination of the value of each symbol or bit in the plurality of interfering signals from a plurality of interfering transmitters after completion of the subsequent iterations of decoding during a symbol interval.

The method above further comprises the steps of: (f) assigning the user or transmitter corresponding to the received signal having the lowest signal strength, based on information from the parameter estimator, to the level of the tree diagram adjacent the leaf nodes for each symbol interval; and (g) assigning the user or transmitter corresponding to the received signals having intermediate levels of signal strength, based on information from the parameter estimator, to the intermediate levels of the tree diagram in descending order from the level of the tree diagram adjacent to the root level to the level of the tree diagram adjacent to the leaf level of the tree for each symbol interval. The iterative signal decoding steps (c) and (d) comprise the steps of: (h) decoding the signals in the tree decoder to determine channel symbol estimates for each of the received interfering signals; (i) decoding each of the received signals in a single user decoder using the channel symbol estimates output from the tree decoder for each signal in step (h) to determine a probability estimate for each of the symbols in each of the signals; and wherein the probability estimates determined in step (i) are used in subsequent iterative decoding in step (h) until a determination is made of the value of each symbol during a symbol interval.

Ideally, during each iteration of decoding of a sequence of bits or symbols, the most likely M channel symbol estimates at each level of the decoding tree are saved, and all the saved M channel symbol estimates are used to determine the best channel symbol estimate for each of the received interfering signals during each symbol interval.

The present invention provides an improved method and apparatus for processing simultaneously occurring, interfering signals using a multi-user detector (MUD) that contains a tree decoder, such as an M-algorithm or T-algorithm tree decoder, which speeds the pruning of a tree by improving tree construction and tree pruning to reduce signal processing time to a minimum. This is done by first using a parameter estimation unit, such as described in the Background of the Invention, to determine a number of unique parameters that uniquely define the characteristics of each of the plurality of received, interfering signals. These parameters include the phase of the oscillator used to generate each received signal, the timing offset relative to the base station clock, carrier frequency, any frequency offset of the carrier, the assigned spreading code, the structure of multi-path replicas and, most importantly, the received power of each of the received signals.

When a decoding tree is constructed in the turbo multi-user detector (MUD), one level of the tree is defined for each of the co-channel, interfering signals. However, unlike the prior art, as described in a paper by Paul D. Alexander, Mark C. Reed, John A. Asenstorfer and Christian B. Schlagel in IEEE Transactions on Communications, vol. 47, number 7, Pages: 1008 -1014, July 1999, entitled "Iterative Multi-User Interference Reduction: Turbo CDMA", the parameter estimation unit determines which of the received signals has the strongest signal strength, and this signal is assigned to the lowest level (root) of the decoding tree. The second strongest signal is assigned to the second level of the tree, and so forth, with the weakest signal being assigned to the highest level of the tree adjacent the terminating nodes or leaves of the tree. By building the tree with the highest power signal being assigned to the first level of the decoding tree a reduced search is more likely to include paths (and nodes) containing the right answer. In other words, due to this power ordering in the tree, a low complexity suboptimal search of the tree will be less likely to chop off branches containing the correct answer, thus supplying the correct answer more often than when power ordering is not used.

This power ordering process of ordering the decoding tree is repeated for each symbol interval of the signals in each block of received data and results in pruning the decoding tree very quickly to properly decode the individual signals making up the co-channel, interfering signal.

In an alternative embodiment of the invention signal processing is done using a turbo multi-user detector (turboMUD) and during each symbol interval the power ordering determined at the beginning of the symbol interval is utilized for all iterations of decoding.

### Description of the Drawings

The invention will be better understood upon reading the following Detailed Description in conjunction with the drawings in which:
Figure 1 is a simplified block diagram circuit of a portion of a prior art receiver that features the teaching of the invention using a tree pruned multi-user decoder with the addition of power ordering of the signal symbols in the levels of a decoding tree for each symbol interval;
Figure 2 shows an equation representing an M-algorithm used to implement power ordering a tree pruned multi-user decoder;
Figure 3 is a simple representation of a decoding tree used to explain the operation of the invention; and
Figure 4 is a simplified block diagram of an alternative embodiment of the invention showing a portion of a prior art receiver circuitry utilizing a turbo multi-user detector performing iterative turbo decoding to separate multiple interfering signals on the same communication channel, with the addition of power ordering of the signal symbols in the levels of a decoding tree for each symbol interval.

### Detailed Description

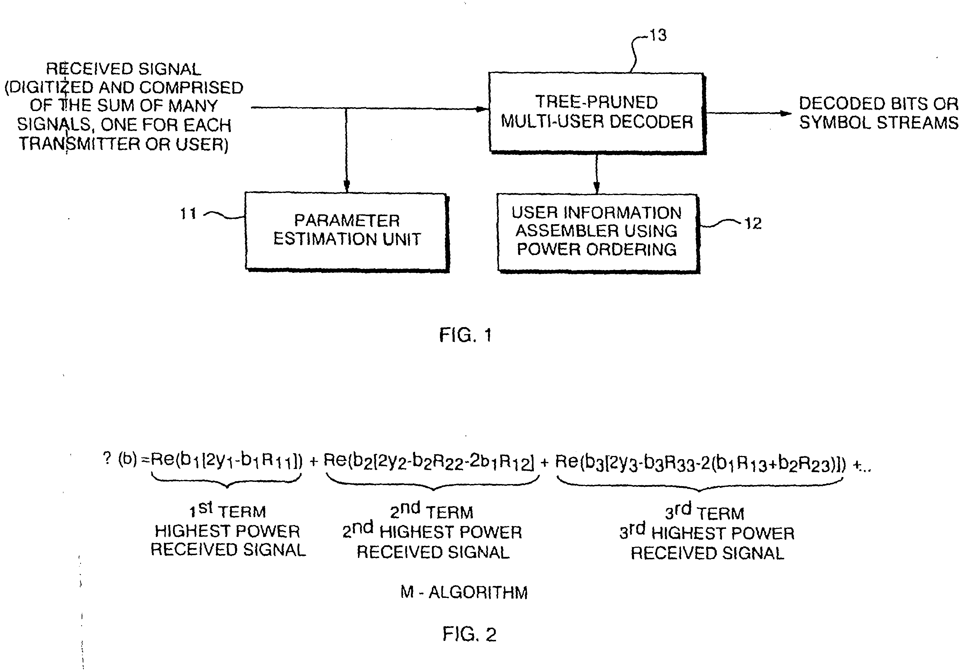

Figure 1 shows a simplified block diagram circuit of a portion of prior art receiver with the novel addition of re-ordering the users assigned to the levels of the tree-pruned, multi-user (MUD) decoder 13 based on the power level of the received signals associated with each user or transmitter at each symbol interval. Not shown in Figure 1 is other typical receiver circuitry used to receive radio frequency signals and that prepare the received signals for decoding by decoder 13. In addition to decoder 13 there is also a parameter estimation unit 11 and a user information assembler using power ordering unit 12.

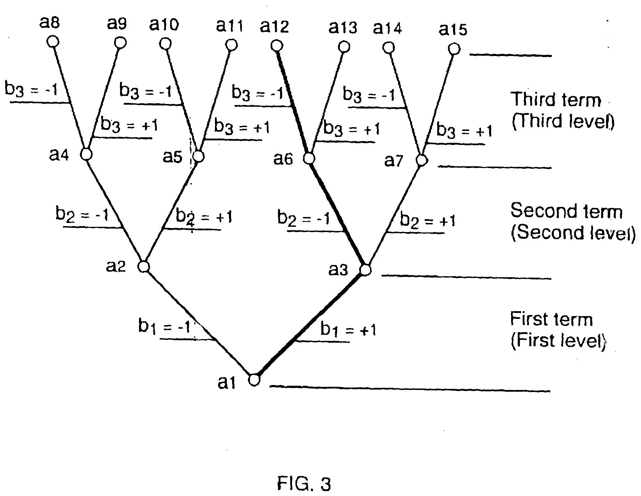

More particularly, with the teaching of the present invention the levels of the decoding tree constructed in decoder 13 (described with reference to Figure 3) are ordered by assembler using power ordering unit 12 such that the received signal having the highest signal strength is assigned to the lowest level (root) of the decoding tree and the weakest signal is assigned to the highest level of the decoding tree adjacent the terminating nodes or leaves of the tree. This power ordering of the levels of the tree is preferably repeated for each symbol interval of the signals being decoded, but may be done on a less frequent basis. This speeds the pruning of a tree by improving tree construction and tree pruning to reduce signal processing time to a minimum.

The multi-user detector 13 is preferably based on the M-algorithm. The M-algorithm is a tree-pruning technique that approximates the operation of a ML Viterbi decoder at reduced complexity, as described in a paper by Paul D. Alexander, Mark C. Reed, John A. Asenstorfer and Christian B. Schlagel in IEEE Transactions on Communications, vol. 47, number 7, Pages: 1008 -1014, July 1999, entitled "Iterative Multi-User Interference Reduction: Turbo CDMA". The M-algorithm is a breadth first decoding algorithm and only the best M paths are retained at each level in the tree. This reduced tree search, referred to as "tree pruning", reduces the number of calculations that must be made and therefore speeds the overall tree processing. The M-algorithm is described in greater detail in the Background of the Invention, and is not repeated here to avoid detracting from the description of the present invention.

The operation of tree-pruned, multi-user detector 13 assumes knowledge of various parameters about the received signals such as relative received timing offsets, carrier phase, frequency offsets, multi-path structure for each of the interfering signals present in the received signal, and the power level of the received signals. A parameter estimation unit 12 is therefore needed. Very briefly, parameter estimation units are used to identify and determine parameters associated with each signal that are required by a multi-user detector (MUD) to allow the MUD to correctly process the received signal and separate out each user's bit stream regardless of the fact that the transmitted signals exist in the same communications bandwidth and at the same instant in time. These parameters include the received power level, the phase of the oscillator which generated each received signal, the timing offset relative to the base station clock, carrier frequency, any frequency offset of the carrier, the assigned spreading code if any is used, and the structure of multi-path replicas. In the present invention the received power is used to order the decoding tree in decoder 13.

The power level information for the received signals is output from parameter estimation unit 11 and is input to assembler using power ordering unit 12. Unit 12 uses this information to build the decoding tree in decoder 13 with the highest power signal being assigned to the first level of the decoding tree, the second strongest signal being assigned to the second level of the tree, and so forth, with the weakest signal of being assigned to the highest level of the tree adjacent the terminating nodes or leaves of the tree.

In addition, this power ordering process is repeated for each symbol interval in each block of received signal data and results in pruning the decoding tree very quickly to properly decode the individual signals making up the co-channel, interfering signals. That is, a newly ordered decoding tree, ordered by power ordering unit 12 as described above, is constructed in decoder 13 for each time interval in which a symbol of each received signal is being received and is to be separated and decoded by decoder 13. Operating in a manner well known in the art, as described in the Alexander et al paper cited in the Summary of the Invention, the multiple, interfering, received signals entering decoder 13 are decoded and decoded data bits/symbol stream are output therefrom are as shown in Figure 1 for each user present on the system.

By building the tree with the highest power signal being assigned to the first level of the decoding tree and successive levels associated with users in decreasing power order, a reduced search is more likely to include paths (and nodes) including the right answer. In other words, due to this power ordering in the decoding tree, a low complexity suboptimal search of the tree will be less likely to chop off branches containing the correct answer, thus supplying the correct answer more often than when power ordering is not used.

For example, let us assume that there are four interfering signals arbitrarily labeled A, B, C & D. Let us also assume that during the first symbol interval the order of the signals in decreasing level of power is B, C, A & D, that during the second symbol interval the order of the signals in decreasing level of power is C, B, D & A, and that during the third symbol interval the order of the signals in decreasing level of power is B, C, D & A. Thus, during decoding of the first symbol, user information assembler 12 uses the power level information to assign signal B to the lowest or root level of the decoding tree, assigns signal C to the second level of the decoding tree, assigns signal A to the third level of the decoding tree, and assigns signal D to the highest or leaf level of the decoding tree. During decoding of the second symbol, user information assembler 12 uses the power level information to assign signal C to the lowest or root level of the decoding tree, assigns signal B to the second level of the decoding tree, assigns signal D to the third level of the decoding tree, and assigns signal A to the highest or leaf level of the decoding tree. Finally, during decoding of the third symbol, user information assembler 12 uses the power level information to assign signal B to the lowest or root level of the decoding tree, assigns signal C to the second level of the decoding tree, assigns signal D to the third level of the decoding tree, and assigns signal A to the highest or leaf level of the decoding tree.

In Figure 2 is shown the mathematical expression of an M-algorithm/metric. As may be seen therein, the first term in the algorithm represents the received signal having the highest power level; the second term in the algorithm/metric represents the received signal having the next highest power level; the third term in the algorithm/metric represents the received signal having the third highest power level; and so forth.

Omega represents the real-valued metric value calculated for a complete path through a tree using the equation; b₁, b₂ etc. are the binary values of a transmitted data symbols of each individual signal in the co-channel, interfering signals and are either a +1 or -1, and both values (+1 and -1) are tried in the equation in each symbol hypothesis to determine the lowest metric value; R₁₁, R₁₂ etc., are entries in the correlation matrix formed by the signature vectors of all the interfering users over the time frame associated with the data sequences of interest, and in the present invention are each calculated using the parameter estimates determined in unit 11 for each of the signals that actually make up the received signal; and y₁, y₂ etc. are vector space representations of the outputs of a bank of matched filters or bank of whitening matched filters (not shown in the Figures but known in the prior art) for all received interfering signals. Each term on the right-hand side of the equation represents a level of the decoding tree and all of the possible hypotheses branching from each node at the previous level.

As previously described, prior art decoders calculate the metrics of many complete paths through a tree between the tree root and each terminating node or leaf of the tree. The path through a tree having the "best" metric value defines the nodes and thereby the value of the "b" terms (+1 or -1) for each individual signal bit comprising the co-channel, interfering signal. Depending on the mathematical representation used for the metric in the tree construction, the path with either the largest or the smallest metric is chosen as the most likely path. The choice of relying on the smallest metric or largest metric is based on which choice produces the highest probability of being correct. The variations associated with these implementation details are well known in the art. While the use of tree pruning algorithms reduces the computational complexity required to determine a "best" path through the decoding tree, their complexity improvement is limited due to bit error rate performance constraints. That is, pruning can eliminate the correct path from consideration within the decoder, causing a decoding error and degrading the overall performance while speeding the processing speed. The tradeoff between processing speed and overall bit error performance is a delicate one that prior art has not resolved to the point of allowing for real time processing for a large number of interfering signals at reasonable bit error rates, especially at high data rates.

In accordance with the teaching of the invention, the order in which hypotheses are examined is changed so that the terms of the M-algorithm/metric are arranged in decreasing levels of signal power. In this way, the number of paths examined in the decoding tree of multi-user decoder 13 from root to leaf is reduced without increasing the likelihood of improperly pruning the true best path through the decoder. Thus, the decoding process is greatly speeded up without affecting overall error performance.

To accomplish this, during the time period of any given symbol interval the equation parameters for the user signal having the highest power level are inserted into the first term of the M-algorithm/metric equation shown in Fig. 2. The value of the first term of the M-algorithm along with the two possible values of "b₁" (+1 and -1) for that user are calculated and saved. Two metric values are calculated, the value of b₁ (+1 or -1) yielding some number "M" of the best metric values are retained. The process progresses from the first term to the second term of the equation.

During the same time period the equation parameters for the user signal having the second highest power level are inserted into the second term of the M-algorithm/metric along with ones of the previously saved surviving estimates of b₁ from the first term of the algorithm and other information from a matched filter or whitening matched filter and parameter estimation unit 11. Metric values are again calculated, the paths and values of b₂ (+1 or -1) combined with the surviving possible estimates for b₁ to yield some number "M" of the best metric values that are again retained.

On the received signal collected during the same time period the process progresses from the second term to the third term of the equation and all subsequent terms of the equation until the pruned tree has been examined to the decoding tree stage containing the leafs. This process results in pruning the tree very efficiently, with both speed and accuracy.

By building the tree for each symbol interval with the user associated with the signal having the highest power level being assigned to the lowest level of the tree and so on, as described above, a reduced search using the M-algorithm based multi-user decoder 13 is more likely to include paths (and nodes) that contain the correct answer. In other words, a low complexity suboptimal search of the tree will be less likely to chop off branches containing the correct answer, thus supplying the correct decoding answer more often than when power ordering is not used.

In Figure 3 is shown a simple representation of a decoding tree used to explain the operation of the invention. It is assumed for this simplified description that severe pruning is occurring and only one path or branch, the path having the lowest calculated metric is of interest. In reality there will be many more branches in each level of the decoding tree and two or more of the lowest value metrics will be saved and used in calculating metric values for the second, third and other terms in the equation. Thus, the darker line between nodes a₁ and a₃ represents the lowest calculated metric value for the first term of the equation and yields a symbol value of +1 for the user having the highest signal strength during the symbol interval. In addition, the branch between nodes a₁ and a₂ is rejected because it does not have the lowest calculated metric value.

The values/parameters for the signal having the second highest power level, as determined by parameter estimation unit 11, are utilized in the second term of the M-algorithm. These values are inserted into the second term of the M-algorithm along with b₁= +1 and the two possible values of "b₂" (+1 and -1), and the value of the second term is calculated for each branch in the second level of the decoding tree. The inserted value of b₂ (+1 or -1) yielding the highest metric value is discarded (between nodes a₃ and a₇) and the inserted value of b₂ (+1 or -1) yielding the lowest metric value is retained. In this simple example this is the branch between nodes a₃ and a₆ and the value of the symbol for the user having the second highest signal strength during the symbol interval is -1. The process has progressed from node a₃ to branch node a₆ and the estimated value of b₂ has been determined as b₂ = -1.

Finally, the values/parameters for the third highest power received signal obtained by parameter estimator 11 are utilized in the third term of the M-algorithm. These values are individually inserted into the third term of the M-algorithm along with b₁ = +1, b2 = -1 and the two possible values of "b₃" (+1 and -1) and the value of the third term is calculated. The inserted value of b₃ (+1 or -1) yielding the highest metric value is discarded and the inserted value of b₃ (+1 or -1) yielding the lowest metric value is retained. In this case the retained symbol value is b₃ = -1. The process has progressed from node a₆ to branch node a₁₂ and the estimated value of b₃ has been determined.

At this point the estimated values for b₁, b₂ and b₃ have been determined and the value of the symbols for three signals comprising the received signal in the signal interval are decoded.

While decoding using a tree where power ordering is utilized as previously described, it must be recognized that sometimes of the two or more paths leading into a level/node in a tree, that the path having the smallest metric may not ultimately yield the smallest overall path metric once extended through the decoding tree because the branch metrics for each branch, even though extending from the same level, are path-dependent and therefore different. That is, it is possible that a path leading into a level which was not the sole surviving path as described in the previous paragraphs, can nonetheless sometimes become a path with a lower path metric once the path has been extended from that level to another level higher in the tree.

In reality, instead of retaining only the metric value for a single path in a tree level as described above (the branch having the lowest metric), the "M" paths having the lowest metric values are retained between all the nodes at that level. Thus, if M=2 then the two paths in each level of the tree having the two lowest metric values is retained. As the metric values for other branches in the pruned tree are determined they are utilized over multiple branches of the decoding tree to determine if the lowest metric value among all the surviving paths has indeed been determined using the teaching of the present invention.

It should be noted that in utilizing the teaching of the present invention to prune the decoding tree in Fig. 3 that the metrics of the great majority of branches and complete paths through the decoding tree are not calculated. Therefore, the tree has been pruned in a very rapid, severe manner.

While the tree shown in Fig. 3 only has three levels reflecting three terms in the M-algorithm for three individual user signals making up a received signal, any number of levels may be constructed into a tree to decode a like number of received signals. In addition, while the example described herein utilizes the M-algorithm, the teaching of the invention may be used with other tree pruning algorithms.

In addition, a rather simple tree example has been used to describe the operation of the invention. If however, more complex signals are being processed, such as Quadrature Phase Shift Keying (QPSK) signals that have additional quadrature terms +j and -j, the complexity of the decoding tree grows exponentially. The first level of the tree shown in Figure 3 will have four branches instead of two, the second level of the tree will have sixteen branches instead of four, and the third level of the tree will have sixty-four branches instead eight. Even with the increased complexity the operation of the invention is as previously described.

Further, any inter-symbol interference can be accommodated by assigning the various echoes of each user's signal a "user number", hence, giving each multi-path replica a level on the tree. This is a simple extension of the subject invention described herein and is commonly understood by one skilled in the art of ML equalization and Viterbi decoding.

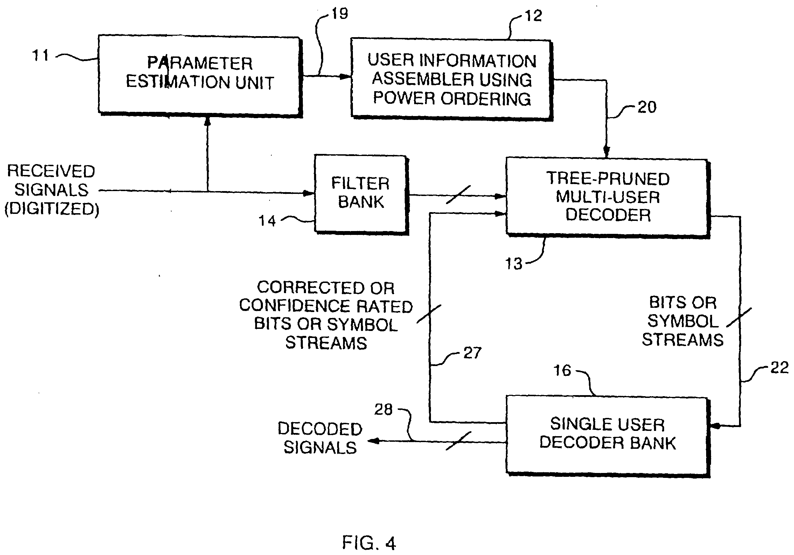

Figure 4 shows a simplified block diagram of a portion of prior art receiver circuitry implementing turbo, iterative decoding for which a tree-pruned, multi-user detector comprise the MUD unit 13 where the ordering of the branches in the decision tree corresponds to the indices of active users and is based on the received power level of each user signal during each symbol interval in accordance with the teaching of the present invention. The assigned order of indices may be changed for every symbol interval as the power level of the received signals changes, as determined by user information assembler unit 12 which receives its information from parameter estimation unit 11. During each symbol interval the power ordered signals are iteratively processed by multi-user decoder (MUD) 13 and bank of single user decoders 16.

If interleaving is applied to the data sequences at the transmitters, deinterleaving and interleaving units (not shown) would be added to the block diagram in Figure 4. For simplicity, Figure 4 considers the case for which interleaving is not present at the transmitters.

A received, digitized signal passes through conventional receiver circuitry (not shown) and is then input to parameter estimation unit 11 which utilizes unique apriori knowledge of the system specification (which characterizes each of the transmitted signal pulses and modulation type) to help identify parameters for each received signal, regardless of the fact that the signals exist in the same communications bandwidth and at the same instant in time. These parameters include the received power, the phase of the oscillator which generated each received signal, the timing offset relative to the base station clock, carrier frequency, any frequency offset of the carrier (phase difference), and the structure of multi-path replicas. This knowledge is typically derived using a parameter estimator in a manner well known in the art, or the training signal method disclosed in the above identified patent application entitled "System For Parameter Estimation And Tracking Of Interfering Digitally Modulated Signals". With the present invention knowledge of the power level of each received signal is required and is passed over lead 19 to the user information assembler unit 12.

The received, digitized signal is then passed through a bank of filters 14 for the purpose of capturing discrete measurements. A whitening matched filter of a type known in the art, which serves to cancel some inter-symbol (ISI) interference as well as reducing the correlation between symbols of interfering users may be used to offer the tree-pruned MUD an advantage, but is not the only choice for this filter bank. An example of such a whitening matched filter is described in detail in a related patent cited at the beginning of this specification.

The whitened, digitized signal output from filter bank 14 is input to tree-pruned multi-user detector (MUD) 13 for iterative processing comprised of MUD 13, line 22, a bank of single user decoders 16, and line 27 back to MUD 13. At the same time power order information, as well as all other parameter values for each detected user, is passed from user information assembler unit 12 to MUD 13 via path 20. The information passed along path 20 tells MUD 13 the order in which to build its decoding tree by assigning the indices of active users within a symbol interval according to the power level of each received signal as determined by parameter estimation unit 11. Responsive thereto, MUD 13 constructs its decoding tree so that the signal having the highest power level is assigned to the lowest or root level of the decoding tree, the signal having the next highest power level is assigned to the second level of the decoding tree, and so on.

In the optimal case, MUD decoder 13 is a full-complexity MAP decoder, if prior information on each received bit is known, or an ML decoder if no prior information exists. Sub-optimal reduced complexity MAP or ML approaches for MUD decoder 12 may be used in an effort to achieve real-time performance. For this alternative embodiment of the invention, MUD 13 is preferably any tree decoder such as the M-algorithm tree decoder described in the Background of the Invention.

The output from multi-user decoder (MUD) 13 may be either hard or soft estimates of the signal symbols and are called "channel symbol estimates" in this description. When soft estimates are calculated they are also known as reliability measures, confidence measures and by other names. Using hard estimates reduces computational complexity, at a cost of degraded performance level. However, in this embodiment of the invention, either type of estimate (soft or hard) is possible for either the output of MUD 13 on line 22 or for the output of the bank of single user error correction decoders on line 27.

The novel difference in the operation of MUD 13 in Figure 4 from the prior art is that the decoding tree that is constructed therein is responsive to power ordering of the users as determined by unit 12 which, for each symbol interval, orders the user indices of the parameter estimates based on the power levels of the different components of the received signal (one corresponding to each user) that comprise the aggregate received signal.

To accomplish this, user information assembler power ordering unit 12 is new. Unit 12 is used to control how MUD 13 constructs its decoding tree for each symbol interval.

The stream of channel symbol estimates for each user presently contributing to the received signal is calculated by MUD 13 and is input to one of a plurality of single-user decoders 16, with there being one single-user decoder 16 used for each user's signal to be decoded, and each decoder 16 corrects the bit or symbol stream over some period of time, typically corresponding to a frame of data. If the single user decoders 16 are soft-output decoders, they calculate conditional probabilities called "probabilities estimates" in this specification, one for each decoded symbol of each user, and output them as probability estimates on line 27. The probability estimates are also known as reliability measures, confidence measures and by other names. Soft-output decoders, such as MAP decoders, soft-output Viterbi algorithm (SOVA) decoders, or soft-output M-algorithm-based decoders, are all well-known in the art. If the single user decoders 16 are hard-output decoders, they calculate hard estimates of the symbols and output them as estimates on line 27. Hard estimates can be considered a special, restricted case of soft estimates, in which only two possible values (0 or 1) of probability estimates are possible. Hard-output decoders, such as Viterbi decoding, hard output M-algorithm, or T- algorithm decoders, are well-known in the art.

At the completion of the first iteration of processing of the signals through single user decoders 16 the individual signal bits then have probability estimates ranging between 0 and 1.0 that are forwarded via lead 27 to MUD 13 to be used in constructing the decoding tree for the next iteration of decoding. During each symbol interval the power ordering information sent over path 20 to MUD 13 remains unchanged.

Since there is only a single user associated with each of decoders 16 it is feasible to use a full-complexity ML or MAP decoder, SOVA decoder, or other hard or soft-output decoder in each single user decoder contained in unit 16 to look at all hypotheses in the single user decoding tree, not just the most likely hypotheses. The single-user decoders 16 each calculate a probability estimate for their respective signal and outputs it on lead 27 for use by MUD 13 in calculating the metrics on each branch of its decoding tree for the next iteration of decoding to allow for the tree-pruned decision algorithm to resemble a MAP-MUD in which prior information about the user bits/symbols can be taken into account.

The passing of information between MUD 13 and the single-user decoders 16 is repeated a predefined number of times, or until the desired bit error rate performance is attained, or until further iterations will result in insignificant changes in the probability estimates output from single user decoders 16 and therefore will not significantly improve the turboMUD bit error rate performance. At that point, the estimates of the decoded signals (i.e. estimates of the data sequences) are output from the single user decoders 16 over path 28. The above described operation is then repeated for the next frame interval.

The process of ordering the decoding tree in MUD 13 according to the power level of the received signals allows the pruning done in the tree decoder within MUD 13 to be done more correctly, or with fewer hypotheses examined, which reduces the overall complexity of the turboMUD detector and allows for real-time operation. Because the user ordering does not rely on confidence values to determine the ordering, the single user decoders can be lower complexity hard-output decoders and an ML version of a tree-pruned MUD can be used instead of the MAP version described in the above paragraphs.

While what has been described herein is the preferred embodiment of the invention it should be obvious to those skilled in the art that the teaching of the present invention may be applied to any field in which tree decoding is utilized, and the invention may be modified without departing from the scope of the invention. For example, the power ordering of the decoding tree maybe changed less frequently than on a per symbol interval basis.

## Claims

1. A method for use in a decoder to decode a sequence of bits or symbols corresponding to a plurality of received interfering user signals, hereinafter also referred as transmitters, that are corrupted by inter-symbol interference and by other interference, to identify the value of the bits or symbols for each of the plurality of received interfering signals during each symbol interval for each of the plurality of received interfering signals, and the decoding method is carried out via a search using a multi-user tree decoder (13) that has a number of levels equal to the number of the plurality of received interfering signals, wherein the tree decoder (13) has a plurality of nodes at each level corresponding to the possible values taken of a bit or symbol, and the tree decoder (13) comprises a root node, intermediate nodes and leaf nodes, and branches connect the root node and intermediate nodes to all nodes at the next higher level, and subsequent decoding is done by single user decoders using output from the multi-user tree decoder (13), and wherein a parameter estimator provides information about each of the plurality of received interfering signals, the received interfering user signals being received in blocks of data, the method comprising the steps of:
a) determining the received signal strength of each transmitter at the beginning of each symbol interval using information from the parameter estimator;
b) assigning the transmitter corresponding to the one of the plurality of received interfering signals determined to have the highest signal strength at the beginning of each symbol interval to the first level of the tree decoder (13) - adjacent the root node for decoding, and there are multiple iterations of decoding during each symbol interval;
c) decoding the received interfering user signals from each transmitter in the multi-user tree decoder (13) to determine symbol estimates for each bit or symbol during each symbol interval of each of the received interfering user signals for a first of multiple iterations of decoding;
(d) decoding the plurality of received interfering signals from the each transmitter in a single user decoder using the symbol estimates determined in step (c) to determine probability estimates for each of the bits and symbols in each of the plurality of received interfering signals for the first iteration of decoding;
(e) repeating steps (c) and (d) for subsequent iterations of multiple iterations of decoding during each symbol interval, with the probability estimates determined in step (d) for one iteration of decoding being used in the multi-user tree decoder (13) in step (c) for a subsequent iteration of decoding; and
(f) making a determination of the value of each symbol or bit in each of the plurality of received interfering signals for each symbol interval using the probability estimates after a number of the subsequent iterations of decoding in step (e) have been performed during each symbol interval.

2. The method in accordance with claim 1, further comprising the steps of:
(g) assigning the transmitter corresponding to one of the plurality of received interfering signals having the lowest signal strength, based on information from the parameter estimator, to the level of the tree decoder (13) adjacent the leaf nodes for each symbol interval; and
(h) assigning the transmitter corresponding to one of the plurality of received interfering signals having intermediate levels of signal strength, based on information from the parameter estimator, to intermediate levels of the tree decoder (13) in descending order from the level of the tree decoder (13) adjacent to the root node to the level of the tree decoder (13) adjacent to the leaf node of the tree decoder (13) for each symbol interval.

3. A method in accordance with claim 2, wherein during each of the multiple iterations of decoding of the bits or symbols occurring during each symbol interval of the plurality of received interfering signals, the most likely M channel symbol estimates at each level of the decoding tree are saved, and all the saved M channel symbol estimates are used to determine the best channel symbol estimate for each of the received interfering signals during each symbol interval.

4. An apparatus comprising:-
a multi-user tree decoder (13) for decoding the received interfering user signals, the decoder having a plurality of nodes at each level corresponding to the possible values taken of a bit or symbol, and the tree decoder (13) comprises a root node, intermediate nodes and leaf nodes, and branches connect the root node and intermediate nodes to all nodes at the next higher level, with the first or highest order term of the decoder tree being assigned to the first or root node level of the decoder tree, the second or next highest term of the decoder tree being assigned to second node level of the decoder tree, and so on;
a parameter estimation unit (11) for determining the received signal strength of the each transmitter at the beginning of each symbol interval;
an assembler (12) for assigning ones of the plurality of received interfering signals to the node levels of the decoder tree based on the received power level of each of the received interfering signals, with the one of the plurality of received interfering signals determined to have the highest received signal strength at the beginning of each symbol interval to the first level of the tree decoder (13) -adjacent the root node for decoding, and there are multiple iterations of decoding during each symbol interval; and
a decoder bank (16) for decoding each of the plurality of received interfering signals in each of the blocks of data to determine symbol estimates for each of the bits and symbols in each of the plurality of received interfering signals for each of the multiple iterations of decoding; and for decoding each of the plurality of received interfering signals using the symbol estimates to determine probability estimates for each of the bits and symbols in each of the plurality of received interfering signals, the probability estimates determined during one iteration of decoding being used in a next iteration of decoding; and for making a determination of the value of each symbol or bit of each of the plurality of received interfering signals for each symbol interval using the probability estimates after a number of the iterations of decoding have been performed during each symbol interval.

5. The apparatus for decoding in accordance with claim 4, wherein the one of the plurality of received interfering signals having the highest received signal strength is assigned to the first or highest order term of the decoder tree for decoding, the one of the plurality of received interfering signals having the second highest signal strength is assigned to the second or next highest order term of the decoder tree for decoding, and so on for all the bits and symbols in each block of data.

6. The apparatus for decoding in accordance with claim 5, wherein the assignment of each of the plurality of received interfering signals to the node levels of the decoder tree is done for every block of data.

7. The apparatus for decoding in accordance with any of claims 4 to 6, wherein the assignment of the plurality of received interfering signals to the levels of the decoder tree is done at the beginning of each block of data.

8. A computer program for carrying out the method in accordance with any one of claims 1 to 3.

9. A computer readable medium containing the computer program in accordance with claim 8.

## Patentansprüche

1. Verfahren zur Anwendung in einem Decoder zum Decodieren einer Sequenz von Bits oder Symbolen entsprechend einer Mehrzahl von empfangenen störenden Benutzersignalen, nachfolgend auch als Sender bezeichnet, die durch Inter-Symbol-Störung oder durch andere Störung verfälscht sind, um den Wert der Bits oder Symbole für jedes der mehreren empfangenen Störsignale in jedem Symbolintervall für jedes der mehreren empfangenen Störsignale zu identifizieren, und das Decodierverfahren über eine Suche mit einem Mehrbenutzer-Baumdecoder (13) durchgeführt wird, der eine Anzahl von Ebenen hat, die gleich der Anzahl der mehreren empfangenen Störsignale ist, wobei der Baumdecoder (13) mehrere Knoten auf jeder Ebene entsprechend den möglichen Werten hat, die ein Bit oder Symbol haben kann, und der Baumdecoder (13) einen Wurzelknoten, Zwischenknoten und Blattknoten umfasst, und Zweige den Wurzelknoten und Zwischenknoten mit allen Knoten auf der nächsthöheren Ebene verbinden, und Folgedecodierung durch Einzelbenutzer-Decoder anhand des Ausgangs von dem Mehrbenutzer-Baumdecoder (13) erfolgt, und wobei ein Parameterschätzglied Informationen über jedes der mehreren empfangenen Störsignale bereitstellt, wobei die empfangenen störenden Benutzersignale in Datenblöcken empfangen werden, wobei das Verfahren die folgenden Schritte beinhaltet:
a) Feststellen der Empfangssignalstärke jedes Senders zu Beginn jedes Symbolintervalls anhand von Informationen von dem Parameterschätzglied;
b) Zuordnen des Senders entsprechend dem einen der mehreren empfangenen Störsignale, von denen festgestellt wurde, dass sie die höchste Signalstärke zu Beginn jedes Symbolintervalls zu der ersten Ebene des Baumdecoders (13) haben, neben dem Wurzelknoten zum Decodieren, wobei es mehrere Decodieriterationen in jedem Symbolintervall gibt;
c) Decodieren der empfangenen störenden Benutzersignale von jedem Sender in dem Mehrbenutzer-Baumdecoder (13) zum Feststellen von Symbolschätzungen für jedes Bit oder Symbol in jedem Symbolintervall von jedem der empfangenen störenden Benutzersignale für eine erste von mehreren Decodieriterationen;
d) Decodieren der mehreren empfangenen Störsignale von jedem Sender in einem Einzelbenutzer-Decoder anhand der Symbolschätzungen, die in Schritt (c) bestimmt wurden, um Wahrscheinlichkeitsschätzungen für jedes der Bits und Symbole in jedem der mehreren empfangenen Störsignale für die erste Decodieriteration zu bestimmen;
e) Wiederholen der Schritte c) und d) für nachfolgende Iterationen von mehreren Decodieriterationen in jedem Symbolintervall, wobei die in Schritt d) für eine Decodieriteration bestimmten Wahrscheinlichkeitsschätzungen in dem Mehrbenutzer-Baumdecoder (13) in Schritt c) für eine nachfolgende Decodieriteration benutzt werden; und
f) Durchführen einer Feststellung des Wertes jedes Symbols oder Bits in jedem der mehreren empfangenen Störsignale für jedes Symbolintervall anhand der Wahrscheinlichkeitsschätzungen, nachdem eine Anzahl der nachfolgenden Decodieriterationen in Schritt e) in jedem Symbolintervall durchgeführt wurde.

2. Verfahren nach Anspruch 1, das ferner die folgenden Schritte beinhaltet:
g) Zuordnen des Senders entsprechend einem der mehreren empfangenen Störsignale der niedrigsten Signalstärke auf der Basis von Informationen von dem Parameterschätzglied zur Ebene des Baumbecoders (13) neben den Blattknoten für jedes Symbolintervall; und
h) Zuordnen des Senders entsprechend einem der mehreren empfangenen Störsignale mit Zwischenebenen von Signalstärke auf der Basis von Informationen von dem Parameterschätzglied zu Zwischenebenen des Baumdecoders (13) in absteigender Reihenfolge von der Ebene des Baumdecoders (13) neben dem Wurzelknoten zur Ebene des Baumdecoders (13) neben dem Blattknoten des Baumdecoders (13) für jedes Symbolintervall.

3. Verfahren nach Anspruch 2, wobei in jeder der mehreren Decodieriterationen der Bits oder Symbole, die in jedem Symbolintervall der mehreren empfangenen Störsignale auftreten, die wahrscheinlichsten M Kanalsymbolschätzungen auf jeder Ebene des Decodierbaums gespeichert werden und alle gespeicherten M Kanalsymbolschätzungen zum Bestimmen der besten Kanalsymbolschätzung für jedes der empfangenen Störsignale in jedem Symbolintervall benutzt werden.

4. Vorrichtung, die Folgendes umfasst:
einen Mehrbenutzer-Baumdecoder (13) zum Decodieren der empfangenen störenden Benutzersignale, wobei der Decoder mehrere Knoten auf jeder Ebene entsprechend den möglichen Werten hat, die ein Bit oder Symbol haben kann, und der Baumdecoder (13) einen Wurzelknoten, Zwischenknoten und Blattknoten umfasst, und Zweige den Wurzelknoten und Zwischenknoten mit allen Knoten auf der nächsthöheren Ebene verbinden, wobei der Term der ersten oder höchsten Ordnung des Decoderbaums der ersten oder Wurzelknotenebene des Decoderbaums zugeordnet wird, wobei der zweite oder nächsthöchste Term des Decoderbaums der zweiten Knotenebene des Decoderbaums zugeordnet wird usw.;
eine Parameterschätzeinheit (11) zum Bestimmen der Empfangssignalstärke jedes Senders zu Beginn jedes Symbolintervalls;
einen Assembler (12) zum Zuordnen von einem der mehreren empfangenen Störsignale zu den Knotenebenen des Decoderbaums auf der Basis des empfangenen Leistungspegels von jedem der empfangenen Störsignale, wobei von dem einen der mehreren empfangenen Störsignale festgestellt wird, dass es die höchste Empfangssignalstärke zu Beginn jedes Symbolintervalls zu der ersten Ebene des Baumdecoder (13) hat, neben dem Wurzelknoten zum Decodieren, wobei es mehrere Decodieriterationen in jedem Symbolintervall gibt; und
eine Decoderbank (16) zum Decodieren jedes der mehreren empfangenen Störsignale in jedem der Datenblöcke zum Bestimmen von Symbolschätzungen für jedes der Bits und Symbole in jedem der mehreren empfangenen Störsignale für jede der mehreren Decodieriterationen; und zum Decodieren jedes der mehreren empfangenen Störsignale anhand der Symbolschätzungen zum Bestimmen von Wahrscheinlichkeitsschätzungen für jedes der Bits und Symbole in jedem der mehreren empfangenen Störsignale, wobei die bei einer Decodieriteration bestimmten Wahrscheinlichkeitsschätzungen in einer nächsten Decodieriteration verwendet werden; und zum Durchführen einer Feststellung des Wertes jedes Symbols oder Bits von jedem der mehreren empfangenen Störsignale für jedes Symbolintervall anhand der Wahrscheinlichkeitsschätzungen, nachdem eine Anzahl der Decodieriterationen in jedem Symbolintervall durchgeführt wurde.

5. Vorrichtung zum Decodieren nach Anspruch 4, wobei das eine der mehreren empfangenen Störsignale mit der höchsten Empfangssignalstärke dem Term der ersten oder höchsten Ordnung des Decoderbaums zum Decodieren zugeordnet wird, wobei das eine der mehreren empfangenen Störsignale mit der zweithöchsten Signalstärke dem Term der zweiten oder nächsthöchsten Ordnung des Decoderbaums zum Decodieren zugeordnet wird, usw., für alle Bits und Symbole in jedem Datenblock.

6. Vorrichtung zum Decodieren nach Anspruch 5, wobei die Zuordnung jedes der mehreren empfangenen Störsignale zu den Knotenebenen des Decoderbaums für jeden Datenblock erfolgt.

7. Vorrichtung zum Decodieren nach einem der Ansprüche 4 bis 6, wobei die Zuordnung der mehreren empfangenen Störsignale zu den Ebenen des Decoderbaums zu Beginn jedes Datenblocks erfolgt.

8. Computerprogramm zum Ausführen des Verfahrens nach einem der Ansprüche 1 bis 3.

9. Computerlesbares Medium, das das Computerprogramm nach Anspruch 8 enthält.

## Revendications

1. Un procédé destiné à une utilisation dans un décodeur de façon à décoder une séquence de bits ou de symboles correspondant à une pluralité de signaux d'utilisateur brouilleurs reçus, ci-après également appelés émetteurs, qui sont corrompus par un brouillage inter-symboles et par d'autres brouillages, de façon à identifier la valeur des bits ou des symboles pour chaque signal de la pluralité de signaux brouilleurs reçus au cours de chaque intervalle de symbole pour chaque signal de la pluralité de signaux brouilleurs reçus, et le procédé de décodage est exécuté par l'intermédiaire d'une recherche au moyen d'un décodeur d'arbre multi-utilisateur (13) qui possède un nombre de niveaux égal au nombre de la pluralité de signaux brouilleurs reçus, où le décodeur d'arbre (13) possède une pluralité de noeuds à chaque niveau correspondant aux valeurs possibles prises par un bit ou un symbole, et le décodeur d'arbre (13) comprend un noeud racine, des noeuds intermédiaires et des noeuds feuilles, et des branches raccordent le noeud racine et les noeuds intermédiaires à tous les noeuds au niveau supérieur suivant, et un décodage subséquent est effectué par des décodeurs à utilisateur unique au moyen d'une sortie à partir du décodeur d'arbre multi-utilisateur (13), et où un estimateur de paramètre fournit des informations relatives à chaque signal de la pluralité de signaux brouilleurs reçus, les signaux d'utilisateur brouilleurs reçus étant reçus par blocs de données, le procédé comprenant les opérations suivantes :
a) la détermination de la puissance de signal reçue de chaque émetteur au début de chaque intervalle de symbole au moyen d'informations provenant de l'estimateur de paramètre,
b) l'attribution de l'émetteur correspondant au signal de la pluralité de signaux brouilleurs reçus déterminé avoir la puissance de signal la plus forte au début de chaque intervalle de symbole au premier niveau du décodeur d'arbre (13) adjacent au noeud racine destiné au décodage, et il y a une pluralité d'itérations de décodage au cours de chaque intervalle de symbole,
c) le décodage des signaux d'utilisateur brouilleurs reçus à partir de chaque émetteur dans le décodeur d'arbre multi-utilisateur (13) de façon à déterminer des estimations de symbole pour chaque bit ou symbole au cours de chaque intervalle de symbole de chacun des signaux d'utilisateur brouilleurs reçus pour une première itération d'une pluralité d'itérations de décodage,
(d) le décodage de la pluralité de signaux brouilleurs reçus à partir de chaque émetteur dans un décodeur à utilisateur unique au moyen des estimations de symbole déterminées à l'étape (c) de façon à déterminer des estimations de probabilité pour chacun des bits et des symboles dans chaque signal de la pluralité de signaux brouilleurs reçus pour la première itération de décodage,
(e) la répétition des étapes (c) et (d) pour des itérations subséquentes d'une pluralité d'itérations de décodage au cours de chaque intervalle de symbole, avec les estimations de probabilité déterminées à l'étape (d) pour une itération de décodage qui est utilisée dans le décodeur d'arbre multi-utilisateur (13) à l'étape (c) pour une itération de décodage subséquente, et
(f) la détermination de la valeur de chaque symbole ou bit dans chaque signal de la pluralité de signaux brouilleurs reçus pour chaque intervalle de symbole au moyen des estimations de probabilité une fois qu'un nombre des itérations de décodage subséquentes à l'étape (e) ont été exécutées au cours de chaque intervalle de symbole.

2. Le procédé selon la Revendication 1, comprenant en outre les étapes suivantes :
(g) l'attribution de l'émetteur correspondant à un signal de la pluralité de signaux brouilleurs reçus possédant la puissance de signal la plus faible, en fonction d'informations provenant de l'estimateur de paramètre, au niveau du décodeur d'arbre (13) adjacent aux noeuds feuilles pour chaque intervalle de symbole, et
(h) l'attribution de l'émetteur correspondant à un signal de la pluralité de signaux brouilleurs reçus possédant des niveaux intermédiaires de puissance de signal, en fonction d'informations provenant de l'estimateur de paramètre, à des niveaux intermédiaires du décodeur d'arbre (13) par ordre décroissant à partir du niveau du décodeur d'arbre (13) adjacent au noeud racine vers le niveau du décodeur d'arbre (13) adjacent au noeud feuille du décodeur d'arbre (13) pour chaque intervalle de symbole.

3. Un procédé selon la Revendication 2, où au cours de chaque itération de la pluralité d'itérations de décodage des bits ou des symboles se déroulant au cours de chaque intervalle de symbole de la pluralité de signaux brouilleurs reçus, les M plus probables estimations de symbole de canal à chaque niveau de l'arbre de décodage sont sauvegardées, et la totalité des M estimations de symbole de canal sauvegardées sont utilisées de façon à déterminer la meilleure estimation de symbole de canal pour chacun des signaux brouilleurs reçus au cours de chaque intervalle de symbole.

4. Un appareil comprenant :
un décodeur d'arbre multi-utilisateur (13) destiné au décodage des signaux d'utilisateur brouilleurs reçus, le décodeur possédant une pluralité de noeuds à chaque niveau correspondant aux valeurs possibles prises par un bit ou un symbole, et le décodeur d'arbre (13) comprend un noeud racine, des noeuds intermédiaires et des noeuds feuilles, et des branches raccordent le noeud racine et les noeuds intermédiaires à tous les noeuds au niveau supérieur suivant, le premier terme ou le terme d'ordre le plus élevé de l'arbre de décodeur étant attribué au premier niveau ou le niveau noeud racine de l'arbre de décodeur, le deuxième terme ou le terme le plus élevé suivant de l'arbre de décodeur étant attribué à un deuxième niveau de noeud de l'arbre de décodeur, et ainsi de suite,
une unité d'estimation de paramètre (11) destinée à la détermination de la puissance de signal reçue de chaque émetteur au début de chaque intervalle de symbole,
un assembleur (12) destiné à l'attribution d'un signal de la pluralité de signaux brouilleurs reçus aux niveaux de noeud de l'arbre de décodeur en fonction du niveau de puissance reçu de chacun des signaux brouilleurs reçus, avec le signal de la pluralité de signaux brouilleurs reçus déterminé avoir la puissance de signal reçue la plus élevée au début de chaque intervalle de symbole au premier niveau du décodeur d'arbre (13) adjacent au noeud racine destiné au décodage, et il y a une pluralité d'itérations de décodage au cours de chaque intervalle de symbole, et
une banque de décodeurs (16) destiné au décodage de chaque signal de la pluralité de signaux brouilleurs reçus dans chacun des blocs de données de façon à déterminer des estimations de symbole pour chacun des bits et des symboles dans chaque signal de la pluralité de signaux brouilleurs reçus pour chaque itération de la pluralité d'itérations de décodage, et au décodage de chaque signal de la pluralité de signaux brouilleurs reçus au moyen des estimations de symbole de façon à déterminer des estimations de probabilité pour chacun des bits et des symboles dans chaque signal de la pluralité de signaux brouilleurs reçus, les estimations de probabilité déterminées au cours d'une itération de décodage étant utilisées dans une itération de décodage suivante, et à la détermination de la valeur de chaque symbole ou bit de chaque signal de la pluralité de signaux brouilleurs reçus pour chaque intervalle de symbole au moyen des estimations de probabilité une fois qu'un nombre des itérations de décodage ont été exécutées au cours de chaque intervalle de symbole.

5. L'appareil de décodage selon la Revendication 4, où le signal de la pluralité de signaux brouilleurs reçus possédant la puissance de signal reçue la plus forte est attribué au premier terme ou au terme d'ordre le plus élevé de l'arbre de décodeur destiné au décodage, le signal de la pluralité de signaux brouilleurs reçus possédant la deuxième puissance de signal la plus forte est attribué au deuxième terme ou au terme d'ordre le plus élevé suivant de l'arbre de décodeur destiné au décodage, et ainsi de suite pour la totalité des bits et des symboles dans chaque bloc de données.

6. L'appareil de décodage selon la Revendication 5, où l'attribution de chaque signal de la pluralité de signaux brouilleurs reçus aux niveaux de noeud de l'arbre de décodeur est effectuée pour chaque bloc de données.

7. L'appareil de décodage selon l'une quelconque des Revendications 4 à 6, où l'attribution de la pluralité de signaux brouilleurs reçus aux niveaux de l'arbre de décodeur est effectuée au début de chaque bloc de données.

8. Un programme informatique destiné à l'exécution du procédé selon l'une quelconque des Revendications 1 à 3.

9. Un support lisible par ordinateur contenant le programme informatique selon la Revendication 8.
